(19) Europäisches Patentamt
European Patent Office
Office européen des brevets

(11) **EP 4 485 809 A1**

(12) **EUROPEAN PATENT APPLICATION**
published in accordance with Art. 153(4) EPC

(43) Date of publication:
**01.01.2025 Bulletin 2025/01**

(21) Application number: **23759645.7**

(22) Date of filing: **03.02.2023**

(51) International Patent Classification (IPC):
**H04B 5/02** $^{(2006.01)}$       **H03H 7/38** $^{(2006.01)}$
**H04B 1/59** $^{(2006.01)}$

(52) Cooperative Patent Classification (CPC):
**H03H 7/38; H04B 1/59; H04B 5/48**

(86) International application number:
**PCT/JP2023/003628**

(87) International publication number:
**WO 2023/162639 (31.08.2023 Gazette 2023/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.02.2022 JP 2022028005**

(71) Applicants:
• **Tokyo Institute of Technology
Tokyo 152-8550 (JP)**
• **Kyocera Corporation
Kyoto-shi, Kyoto 612-8501 (JP)**

(72) Inventors:
• **ISHIHARA, Noboru
Tokyo 152-8550 (JP)**
• **TSURU, Shinsuke
Kyoto-shi, Kyoto 612-8501 (JP)**
• **ISOYAMA, Shinji
Kyoto-shi, Kyoto 612-8501 (JP)**
• **TOBA, Tatsuo
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **TRANSMISSION CIRCUIT AND COMPOSITE TRANSMISSION CIRCUIT**

(57)    A transmission circuit includes a plurality of impedance circuits, each of which has a different impedance, a plurality of switch elements, any one of which is being connected to a respective one of the plurality of impedance circuits, a compensation circuit connected to a respective one of the plurality of switch elements and selectively adding a capacitance value and a resistance value to the transmission circuit, and a control circuit controlling opening/closing of the plurality of switch elements. The control circuit is controllable to selectively change the opening/closing of the plurality of switch elements and to rotate a reflection coefficient of an output terminal on an antenna side in a complex plane.

FIG. 1

## Description

### TECHNICAL FIELD

The present disclosure relates to a transmission circuit and a composite transmission circuit.

### BACKGROUND OF INVENTION

A backscatter system is known as a data communication method for wireless communication devices. For example, Patent Document 1 discloses a technique to achieve a single sideband by suppressing either an upper sideband (USB) signal or a lower sideband (LSB) signal using a demultiplexer/multiplexer.

### CITATION LIST

### PATENT LITERATURE

Patent Document 1: JP 2005-323223 A

### SUMMARY

A transmission circuit according to one aspect of the present disclosure is configured to be connected to an antenna. The transmission circuit includes a plurality of impedance circuits having different impedance from each other, a plurality of switch elements each of which is connected to a respective one of the plurality of impedance circuits; a compensation circuit connected to each of the plurality of switch elements and selectively adding a capacitance value and a resistance value to the transmission circuit, and a control circuit controlling opening/closing of the plurality of switch elements. The control circuit is controllable to selectively change the opening/closing of the plurality of switch elements and to rotate a reflection coefficient of an output terminal on the antenna side in a complex plane.

A composite transmission circuit in one aspect of the present disclosure is configured to be connected to an antenna. The composite transmission circuit includes at least a first transmission circuit having a first characteristic related to a capacitance value and a resistance value, a second transmission circuit having a second characteristic different from the first characteristic with reselected to a capacitance value and a resistance value, and a third transmission circuit having a third characteristic different from the first characteristic and the second characteristic with respect to a capacitance value and a resistance value. The composite transmission circuit includes a switch control circuit configured to selectively connect the first transmission circuit, the second transmission circuit, and the third transmission circuit to the antenna. Each of the first transmission circuit, the second transmission circuit, and the third transmission circuit includes a plurality of impedance circuits having different impedance from each other, a plurality of switch elements each of which is connected to a respective one of the plurality of impedance circuits, and a control circuit controlling opening/closing of the plurality of switch elements. The control circuit is controllable to selectively change the opening/closing of the plurality of switch elements and to rotate a reflection coefficient of an output terminal on the antenna side in a complex plane.

### BRIEF DESCRIPTION OF THE DRAWINGS

FIG. 1 is a block diagram illustrating an example of a configuration of a wireless communication device according to a first embodiment.
FIG. 2 is a diagram for describing a method of rotationally controlling impedance in a complex plane according to the first embodiment.
FIG. 3A is a diagram for describing changes in a backscatter signal.
FIG. 3B is a diagram for describing changes in a backscatter signal.
FIG. 3C is a diagram for describing changes in a backscatter signal.
FIG. 4 is a diagram illustrating an example of a configuration of a transmission circuit according to the first embodiment.
FIG. 5 is a diagram for describing a method of rotationally controlling the reflection coefficient in the complex plane according to the first embodiment.
FIG. 6 is a block diagram illustrating an example of a configuration of a wireless communication device according to a second embodiment.
FIG. 7 is a diagram for describing an example of a configuration of a transmission circuit according to the second embodiment.
FIG. 8 is a diagram for describing an example of a configuration of a compensation circuit according to the second embodiment.
FIG. 9 is a block diagram illustrating an example of a configuration of a wireless communication device according to a third embodiment.
FIG. 10 is a diagram for describing an example of a configuration of a composite transmission circuit according to the third embodiment.
FIG. 11 is a diagram for describing a method of rotationally controlling the reflection coefficient in the complex plane according to the third embodiment.

### DESCRIPTION OF EMBODIMENTS

Hereinafter, an embodiment of the present disclosure will now be described in detail with reference to the accompanying drawings. Note that the present disclosure is not limited by this embodiment, and when there is more than one embodiment, the present disclosure includes combinations of the individual embodiments. In the following embodiments, the same reference signs are assigned to the same portions and redundant descriptions thereof will be omitted.

First Embodiment

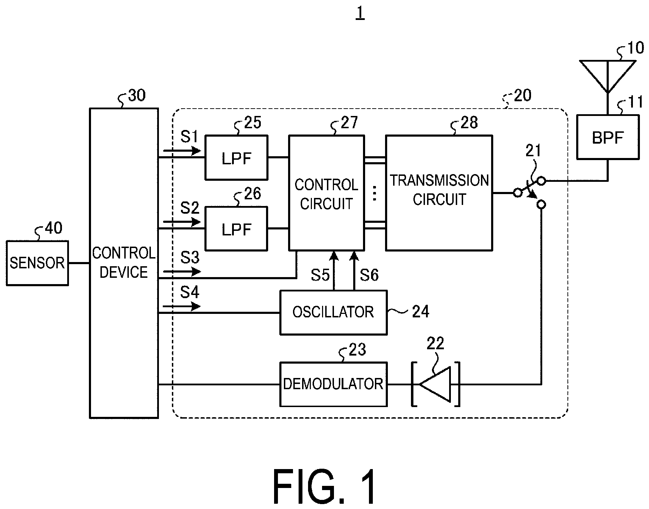

A configuration of a wireless communication device according to a first embodiment will be described with reference to FIG. 1. FIG. 1 is a block diagram illustrating an example of the configuration of the wireless communication device according to the embodiment.

As illustrated in FIG. 1, a wireless communication device 1 includes an antenna 10, a band pass filter (BPF) 11, a radio frequency back scatter (RFBS) device 20, a control device 30, and a sensor 40. The wireless communication device 1 is a communication device performing backscatter wireless communication such as RFID.

The antenna 10 receives signals transmitted to the wireless communication device 1. The antenna 10 transmits radio waves towards the outside of the wireless communication device 1. The BPF 11 is a filter passing signals in a desired frequency band.

The RFBS device 20 includes a radio frequency switch 21, an amplifier 22, a demodulator 23, an oscillator 24, a low-pass filter (LPF) 25, an LPF 26, a control circuit 27, and a transmission circuit 28. The RFBS device 20 is a wireless communication device supporting backscatter data communication. The backscatter data communication utilizes reflection of transmitted radio waves to perform communication.

The radio frequency switch 21 switches connection between the antenna 10 and a transmission circuit system or a receiving circuit system. The radio frequency switch 21 can connect the transmission circuit system to the antenna 10. The wireless communication device 1 transmits signals when the antenna 10 and the transmission circuit system are connected. The radio frequency switch 21 can connect the receiving circuit system to the antenna 10. The transmission circuit system includes the oscillator 24, the LPF 25, the LPF 26, the control circuit 27, and the transmission circuit 28. The receiving circuit system includes the amplifier 22 and the demodulator 23.

The amplifier 22 amplifies and outputs a signal received from the antenna 10. The amplifier 22 outputs the amplified signal to the demodulator 23. The demodulator 23 performs a demodulation process on the input signal. The demodulator 23 demodulates the signal received from the amplifier 22. For example, the demodulator 23 performs the demodulation process on the signal received from the amplifier 22 (a modulated signal such as amplitude shift keying (ASK)).

In the control device 30, for example, a program stored inside is executed by a processor or the like, using a random access memory (RAM) or the like as a work area. The control device 30 can be a controller. The control device 30 may also be implemented by an integrated circuit such as an application specific integrated circuit (ASIC) or a field programmable gate array (FPGA). The control device 30 may be implemented by a combination of software and hardware.

The control device 30 outputs a serial data S1 to the control circuit 27 via the LPF 25. The serial data S1 is based on the output data from the sensor 40. The control device 30 outputs a serial data S2 to the control circuit 27 via the LPF 26. The serial data S2 is based on the output data from the sensor 40. The serial data S1 has a phase different from the serial data S2 by approximately 90°.

The control device 30 outputs a control signal S3 to the control circuit 27. The control signal S3 may be utilized to suppress either the USB signal or the LSB signal with respect to a carrier signal. The control device 30 outputs a control signal S4 to the oscillator 24. The control signal S4 may be utilized to control a channel used for communication.

The sensor 40 detects various physical quantities. The physical quantities detected by the sensor 40 are not limited to any specific physical quantities. The sensor 40 can include, for example, a temperature sensor detecting a temperature around the wireless communication device 1 and/or an acceleration sensor detecting acceleration occurring in the wireless communication device 1. The sensor 40 may include other sensors.

The oscillator 24 generates an oscillation signal with a predetermined frequency. The oscillator 24 generates an oscillation signal S5 according to the control signal S4. The oscillator 24 generates an oscillation signal S6 having a phase 90° different from that of the oscillation signal S5.

The control circuit 27 controls the transmission circuit 28. The control circuit 27 controls the transmission circuit 28 to adjust a value of impedance of the transmission circuit 28 based on the serial data S1, the serial data S2, and the control signal S3. The control circuit 27 changes the impedance of the transmission circuit 28. Due to the change in impedance, a reflection coefficient of an output terminal on the antenna 10 side rotates in the complex plane. The control circuit 27 changes the impedance of the transmission circuit 28 to control the reflection coefficient of the output terminal to rotate in the complex plane. For example, the control circuit 27 controls the impedance of the transmission circuit 28 so as to reduce the USB signal or LSB signal relative to the carrier signal in the reflected signal (hereinafter also referred to as a backscatter signal), to realize a single sideband.

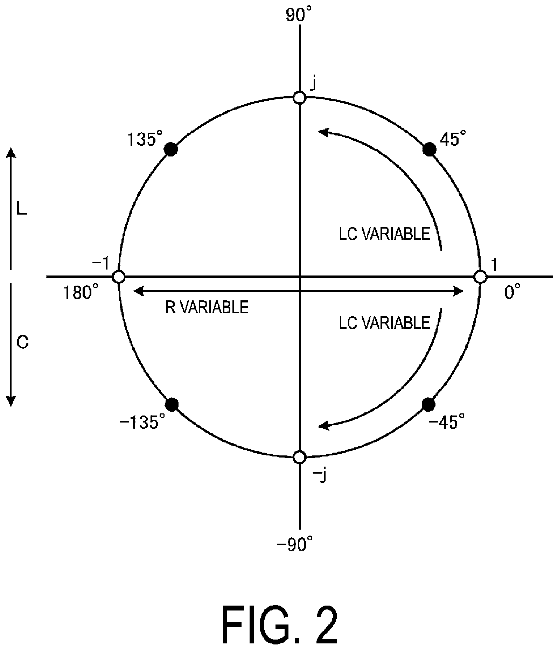

A method will be described by using a polar chart (polar coordinate) in FIG. 2, in which the control circuit 27 controls the reflection coefficient of the output terminal on the antenna 10 side of the transmission circuit 28 so as to rotate on the complex plane of the polar chart. FIG. 2 is a diagram for describing how the control circuit 27 changes the impedance of the transmission circuit 28 and controls the reflection coefficient of the output terminal so as to rotate.

FIG. 2 is a diagram illustrating changes in a reflection coefficient Γ due to changes in impedance on the polar chart. The impedance is calculated by the following equation (1). In equation (1), Z is impedance, R is resistance, j is imaginary number, ω is angular frequency, L is inductance, and C is capacitance.

$$Z = R + j(\omega L - 1/\omega C) \qquad (1)$$

The reflection coefficient Γ is represented by the following equation.

$$\Gamma = (Z - Z_0)/(Z + Z_0) \qquad (2)$$

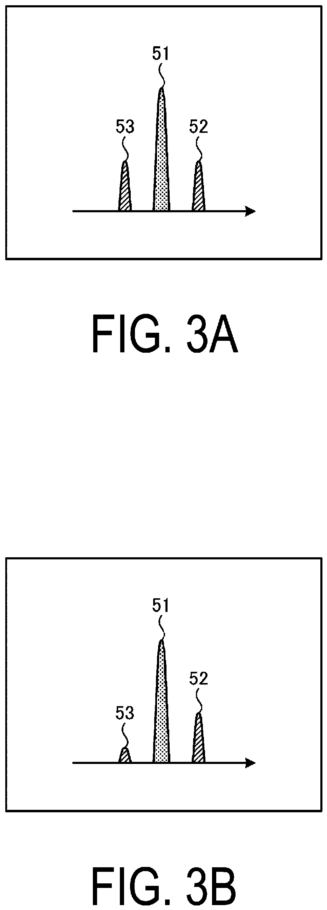

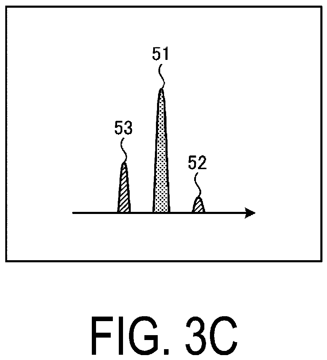

Here, $Z_0$ is impedance of the antenna 10 or the BPF 11.
The control circuit 27 selectively controls the impedance Z so that the reflection coefficient Γ rotates around a reference point. The reference point may be, but is not limited to, the origin and may be any point. The closer to the origin the reference point is, the closer signal to the ideal one the transmission circuit can obtain. The more a periphery of the reference point is controlled to circularly rotate, the closer signal to the ideal one the transmission circuit can obtain. In the Smith chart, a lower semicircular region indicates capacitive properties, and an upper half indicates inductance properties. A change on the real axis represents a change in a resistance value.
The transmission circuit 28 includes a plurality of impedances. The control circuit 27 can selectively control each of the plurality of impedances. For example, the control circuit 27 controls the impedance of the transmission circuit 28 in 45° increments of 0°, 45°, 90°, 135°, 180°, -135°, -90°, -45°. The control circuit 27 can control the impedance to rotate discretely by sequentially changing the impedance of the transmission circuit 28. The control circuit 27 discretely rotates the reflection coefficient Γ by discretely rotating the impedance.
The control circuit 27 can change the impedance counterclockwise according to the order of changing the impedance of the transmission circuit 28. The control circuit 27 can change the reflection coefficient Γ counterclockwise by rotating the impedance counterclockwise. When the reflection coefficient is controlled to rotate counterclockwise, the reflected signal for the radio frequency (RF) is only the upper sideband (USB) signal. When the reflection coefficient is controlled to rotate clockwise, only the low sideband (LSB) signal is obtained. At that time, the frequency of the reflected signal is detuned from the RF signal frequency by a rotational speed frequency. FIGs. 3A, 3B, and 3C are used to describe several examples of changes in the backscatter signal by changing the impedance to control the reflection coefficient.
FIG. 3A is a diagram illustrating a frequency spectrum for describing a state of a backscatter signal when the control circuit 27 controls only the resistive component of the impedance to change the reflection coefficient Γ on the real axis of the polar chart (FIG. 2). The horizontal axis represents the frequency, and the vertical axis represents the intensity of the RF signal and the reflected signal. FIG. 3A illustrates a carrier signal 51, a USB signal 52, and an LSB signal 53. When the resistive component is controlled, the reflection coefficient Γ is controlled to be either 0° or 180° on the real axis. When the reflection coefficient Γ is controlled by changing the impedance only with the resistive component, as illustrated in FIG. 3A, for example, when switching from 0° to 180°, the clockwise signal component and the counterclockwise signal component are included. The signal components in the two rotational directions are present, and thus the USB signal 52 and the LSB signal 53 appear simultaneously, and only one of the signals cannot be selectively suppressed. As a result, the SSB signal cannot be obtained by controlling only the resistive component.
FIG. 3B is a diagram illustrating a frequency spectrum for describing changes in a backscatter signal when the control circuit 27 changes the inductance or capacitance of the impedance so that the locus of the reflection coefficient Γ is circular. The horizontal axis represents the frequency, and the vertical axis represents the intensity of the RF signal and the reflected signal. Based on equations (1) and (2), the control circuit 27 can control the impedance to rotate counterclockwise by controlling the value of the inductance. At this time, the impedance is rotated counterclockwise, for example, from 0° to 45°, 90°, and 135°. The control circuit 27 can further control the impedance to rotate counterclockwise by controlling the value of the capacitance. At this time, the impedance is rotated counterclockwise, for example, from 180° to -135°, -90°, and -45°. As illustrated in FIG. 3B, the control circuit 27 can reflect the transmitted RF signal while suppressing the LSB signal 53 by controlling the impedance to rotate counterclockwise. In other words, the control circuit 27 can obtain a backscatter signal in which the USB signal 52 is selected as the SSB signal by controlling the impedance to rotate counterclockwise.
FIG. 3C is a diagram illustrating a frequency spectrum for describing a change in the backscatter signal when the control circuit 27 changes capacitance/inductance of the impedance to control a trajectory of the reflection coefficient Γ to form a circle. The horizontal axis represents the frequency, and the vertical axis represents the intensity of the RF signal and the reflected signal. Based on equations (1) and (2), the control circuit 27 can control the impedance to rotate clockwise by controlling the value of the capacitance. At this time, the impedance is rotated clockwise, for example, from 0° to -45°, -90°, and -135°. The control circuit 27 can further control the impedance to rotate clockwise by controlling the value of the inductance. At this time, the impedance is rotated clockwise, for example, to 180°, 135°, 90°, and 45°. As illustrated in FIG. 3C, the control circuit 27 can reflect the transmitted RF signal while suppressing the USB signal 52 by controlling the impedance to rotate clockwise. In other words, the control circuit 27 can obtain a backscatter signal in which the LSB signal 53 is selected as the SSB signal by controlling the impedance to rotate clockwise.

The transmission circuit 28 is disposed at a front end of the wireless communication device 1. The transmission circuit 28 is a circuit performing backscatter communication in which the transmitted radio waves are reflected as backscatter signals. The transmission circuit 28 is connected to the antenna 10. The transmission circuit 28 includes a plurality of impedance circuits each of which has different impedance. Each of the plurality of impedance circuits includes a switch element. The switch element switches connection of the corresponding impedance circuit. The control circuit 27 switches connection of each of the plurality of impedance circuits by controlling each of the plurality of switch elements. The control circuit 27 controls the impedance of the transmission circuit 28 by controlling the plurality of switch elements.

Configuration of Transmission Circuit

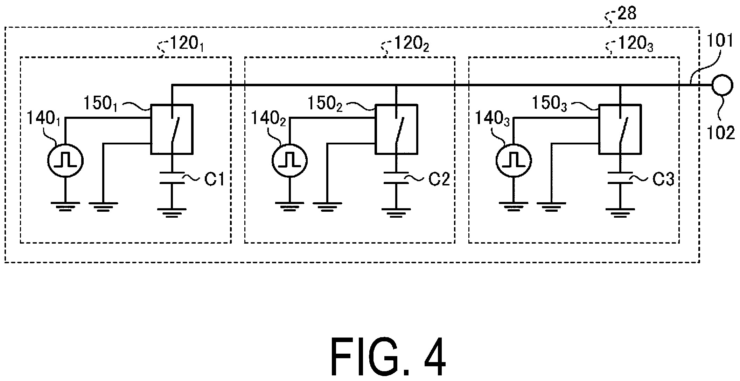

A configuration of the transmission circuit according to the first embodiment will be described with reference to FIG. 4. FIG. 4 is a diagram for describing an example of a configuration of the transmission circuit according to the first embodiment.

As illustrated in FIG. 4, the transmission circuit 28 includes capacitor circuits $120_1$ to $120_3$. The capacitor circuits $120_1$ to $120_3$ include signal sources $140_1$ to $140_3$ and switch elements $150_1$ to $150_3$, respectively. When it is not necessary to particularly distinguish the switch elements $150_1$ to $150_3$ from one another, they may be collectively referred to as a switch element 150.

The capacitor circuits $120_1$ to $120_3$ are electrically connected to one another by a signal line 101. The signal line 101 is electrically connected to an input/output terminal 102. The capacitor circuits $120_1$ to $120_3$ are circuits used in rotationally controlling the reflection coefficient clockwise or counterclockwise from -135° to -90° and from -90° to 0° in the complex plane (polar chart).

The capacitor circuit $120_1$ includes a signal source $140_1$, a switch element $150_1$, and a capacitor C1. The signal source $140_1$ indicates a signal source to which the control signal from the control circuit 27 is supplied. The signal source $140_1$ outputs the control signal to the switch element $150_1$ to control an opening/closing operation of the switch element $150_1$. The switch element $150_1$ includes one input terminal to which the signal source $140_1$ is connected and the other input terminal to which a reference potential is connected. The reference potential is described as being the ground, but the present disclosure is not limited thereto. The switch element $150_1$ switches between a closed state and an open state in accordance with the control signal from the

signal source $140_1$.

The switch element $150_1$ includes one end to which the signal line 101 is electrically connected and the other end to which one end of the capacitor C1 is electrically connected. The other end of the capacitor C1 is connected to the reference potential. In this case, the switch element $150_1$ electrically connects the signal line 101 and the capacitor C1 by being in the closed state. The switch element $150_1$ electrically separates the signal line 101 from the capacitor C1 by being in the open state. The capacitance of the capacitor C1 is added to the impedance of the transmission circuit 28 by electrically connecting the signal line 101 and the capacitor C1. In other words, a reactance component of the impedance of the transmission circuit 28 changes due to addition of the capacitance of the capacitor C 1.

The capacitor circuit $120_2$ includes a signal source $140_2$, a switch element $150_2$, and a capacitor C2. The signal source $140_2$ indicates a signal source to which the control signal from the control circuit 27 is supplied. The signal source $140_2$ outputs the control signal to the switch element $150_2$ to control the opening/closing operation of the switch element $150_2$. The switch element $150_2$ includes one input terminal to which the signal source $140_2$ is connected and the other input terminal to which the reference potential is connected. The reference potential is described as being the ground, but the present disclosure is not limited thereto. The switch element $150_2$ switches between the closed state and the open state in accordance with the control signal from the signal source $140_2$.

The switch element $150_2$ includes one end to which the signal line 101 is electrically connected and the other end to which one end of the capacitor C2 is electrically connected. The other end of the capacitor C2 is connected to the reference potential. In this case, the switch element $150_2$ electrically connects the signal line 101 and the capacitor C2 by being in the closed state. The switch element $150_2$ electrically separates the signal line 101 from the capacitor C2 by being in the open state. The capacitance of the capacitor C2 is added to the impedance of the transmission circuit 28 by electrically connecting the signal line 101 and the capacitor C2. In other words, a reactance component of the impedance of the transmission circuit 28 changes due to addition of the capacitance of the capacitor C2.

The capacitor circuit $120_3$ includes a signal source $140_3$, a switch element $150_3$, and a capacitor C3. The signal source $140_3$ indicates a signal source to which the control signal from the control circuit 27 is supplied. The signal source $140_3$ outputs the control signal to the switch element $150_3$ to control the opening/closing operation of the switch element $150_3$. The switch element $150_3$ includes one input terminal to which the signal source $140_3$ is connected and the other input terminal to which the reference potential is connected. The reference potential is described as being the ground, but the present disclosure is not limited thereto. The

switch element $150_3$ switches between the closed state and the open state in accordance with the control signal from the signal source $140_3$. Note that one or more capacitor circuits among the capacitor circuits $120_1$ to $120_3$ may include one or more electrical elements among a plurality of inductor elements and the plurality of resistive elements.

The switch element $150_3$ includes one end to which the signal line 101 is electrically connected and the other end to which one end of the capacitor C3 is electrically connected. The other end of the capacitor C3 is connected to the reference potential. In this case, the switch element $150_3$ electrically connects the signal line 101 and the capacitor C3 by being in the closed state. The switch element $150_3$ electrically separates the signal line 101 from the capacitor C3 by being in the open state. The capacitance of the capacitor C3 is added to the impedance of the transmission circuit 28 by electrically connecting the signal line 101 and the capacitor C3. In other words, a reactance component of the impedance of the transmission circuit 28 changes due to addition of the capacitance of the capacitor C3.

The control circuit 27 can control the impedance of the transmission circuit 28 to rotate in the complex plane by controlling the open/closed state of each of the switch elements $150_1$ to $150_3$. The control circuit 27 is controllable to rotate the impedance of the transmission circuit 28 in the complex plane by causing any one of the switch elements $150_1$ to $150_3$ to be in the closed state or by causing all of the switch elements to be in the open state. The control circuit 27 may be controllable to rotate the impedance of the transmission circuit 28 in the complex plane by causing the plurality of switch elements among the switch elements $150_1$ to $150_3$ to be in the open state.

When all of the switch elements $150_1$ to $150_3$ are in the open state, the transmission circuit 28 is configured such that the impedance is located at 0° in the complex plane. When only the switch element $150^1$ is in the closed state, the transmission circuit 28 is configured such that the impedance is located at -45°. When only the switch element $150_2$ is in the closed state, the transmission circuit 28 is configured such that the impedance is located at -90°. When only the switch element $150_3$ is in the closed state, the transmission circuit 28 is configured such that the impedance is located at -135°. In other words, the control circuit 27 may control the position of the impedance on the complex plane with four-point switching by controlling the switch elements $150_1$ to $150_3$. The capacitor circuits $120_1$ to $120_3$ may rotationally control the impedance between -135° and -90° and between -90° and 0°. The control circuit 27 rotationally controls the impedance of the transmission circuit 28 clockwise by sequentially causing only one of the switch elements $150_1$, $150_2$, and $150_3$ to be in the closed state. The control circuit 27 rotationally controls the impedance of the transmission circuit 28 counterclockwise by sequentially causing only one of the switch elements $150_3$,

$150_2$, and $150_1$ to be in the closed state.

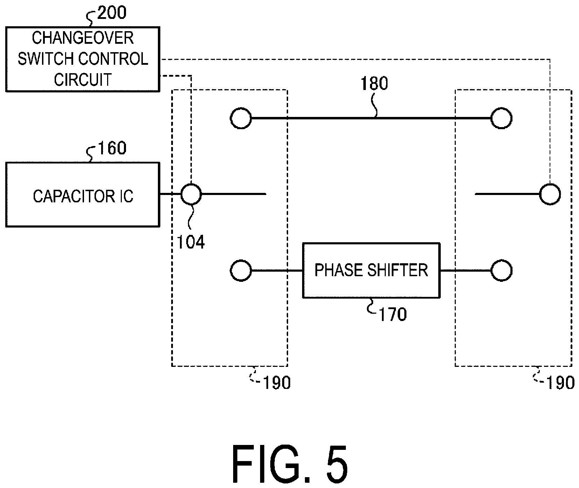

A method of rotationally controlling the impedance in the complex plane in the transmission circuit according to the first embodiment will be described with reference to FIG. 5. FIG. 5 is a diagram for describing a method of rotationally controlling the reflection coefficient in the complex plane according to the first embodiment.

As illustrated in FIG. 5, the transmission circuit 28 (the capacitor circuits $120_1$ to $120_3$) illustrated in FIG 4 may be integrated and used as a capacitor IC 160. In this case, the capacitor IC 160 is connected to either a phase shifter 170 or a signal line 180 by switching of a changeover switch element 190 by a changeover switch control circuit 200.

The phase shifter 170 includes a capacitor, an inductor, and a capacitor, which are not illustrated. The phase shifter 170 shifts a phase of the input signal by 90° to output the shifted signal.

The changeover switch control circuit 200 controls the changeover switch element 190 to connect the capacitor IC 160 and the signal line 180 when rotationally controlling the impedance between 0° and -90° and between -90° and -135°.

The changeover switch control circuit 200 controls the changeover switch element 190 to connect the capacitor IC 160 and the phase shifter 170 when rotationally controlling the impedance between 45° and 90° and between 90° and 180°. The position of the impedance on the complex plane can be controlled with eight-point switching by connecting the capacitor IC 160 and the phase shifter 170. By forming an integrated circuit in this manner, a configuration advantageous for miniaturization can be obtained. In the present embodiment, the control circuit 27 and the changeover switch control circuit 200 may be integrally configured.

Second Embodiment

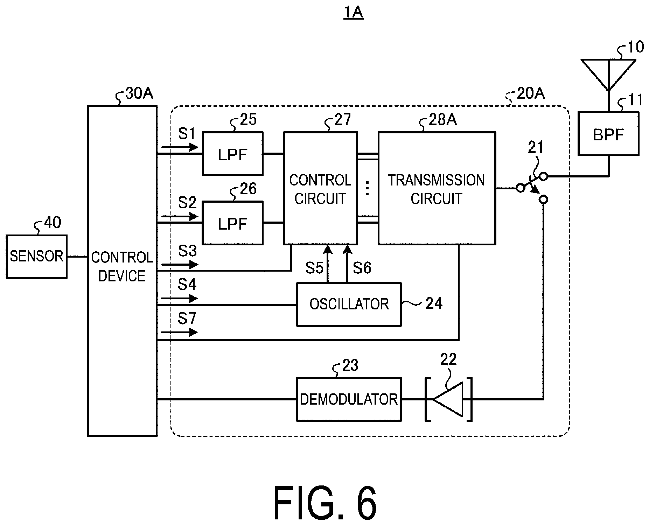

A configuration of a wireless communication device according to the second embodiment will be described with reference to FIG. 6. FIG. 6 is a block diagram illustrating an example of the configuration of the wireless communication device according to the second embodiment.

As illustrated in FIG. 6, a wireless communication device 1A is different from the wireless communication device 1 illustrated in FIG. 1 in that a control device 30A outputs a control signal S7 to a transmission circuit 28A of an RFBS device 20A. The control signal S7 is a control signal used to control a compensation circuit, which will be described later, compensating a capacitance value and a resistance value of the capacitor circuit 120.

Configuration of Transmission Circuit

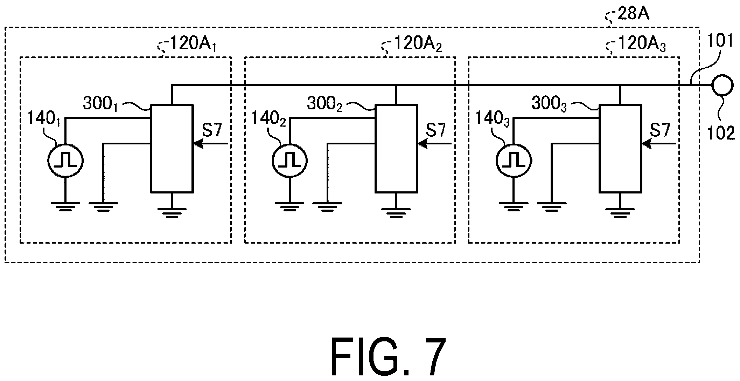

A configuration of the transmission circuit according to the second embodiment will be described with reference to FIG. 7. FIG. 7 is a diagram for describing an example of a configuration of the transmission circuit according to the second embodiment.

As illustrated in FIG. 7, the transmission circuit 28A is different from the transmission circuit 28 illustrated in FIG. 4 in that the capacitor circuits $120A_1$ to $120A_3$ include compensation circuits $300_1$ to $300_3$ instead of the switch elements $150_1$ to $150_3$ and the capacitors C1 to C3, respectively. When it is not necessary to particularly distinguish the compensation circuits $300_1$ to $300_3$ from one another, these may be collectively referred to as a compensation circuit 300.

The compensation circuit 300 adds a capacitance value and a resistance value to the capacitor circuit 120A. The compensation circuit 300 is configured such that the capacitance value and the resistance value can be changed by a control signal from the control device 30A.

Configuration of Compensation Circuit

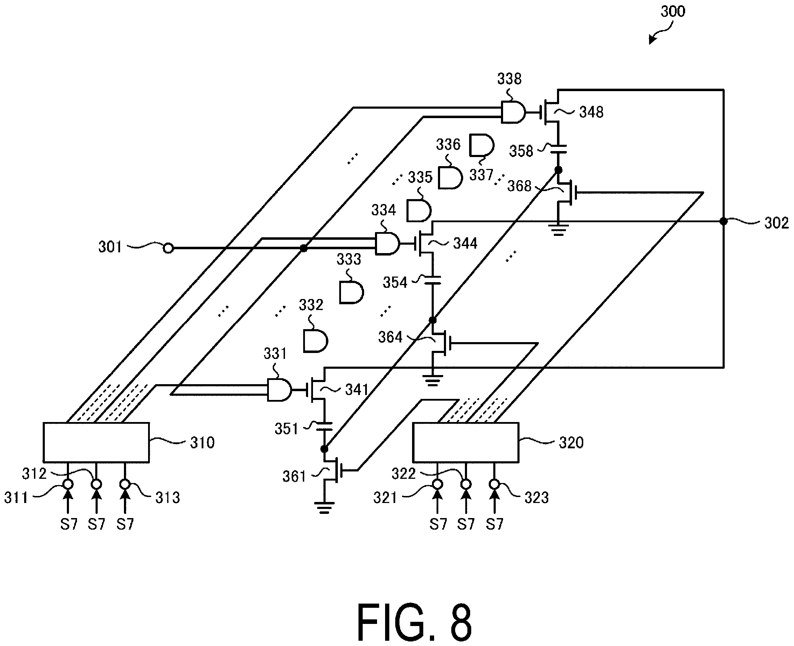

A configuration of the compensation circuit according to the second embodiment will be described with reference to FIG. 8. FIG. 8 is a diagram for describing an example of the configuration of the compensation circuit according to the second embodiment.

As illustrated in FIG. 8, the compensation circuit 300 includes a capacitance selector 310, a resistance selector 320, AND gate circuits 331 to 338, capacitance transistors 341 to 348, capacitors 351 to 358, and compensation transistors 361 to 368. When it is not necessary to particularly distinguish the AND gate circuits 331 to 338 from one another, these may be collectively referred to as an AND gate circuit 330. When it is not necessary to particularly distinguish the capacitance transistors 341 to 348 from one another, these may be collectively referred to as a capacitance transistor 340. When it is not necessary to particularly distinguish the capacitors 351 to 358 from one another, these may be collectively referred to as a capacitor 350. When it is not necessary to particularly distinguish the compensation transistors 361 to 368 from one another, these may be collectively referred to as a compensation transistor 360.

The capacitance selector 310 includes a first input terminal 311, a second input terminal 312, and a third input terminal 313. The capacitance selector 310 is configured such that the control signals S7 from the control device 30A are input to the first to third input terminals 311 to 313, respectively. That is, the capacitance selector 310 is a 3-bit selector. In the second embodiment, the capacitance selector 310 will be described as the 3-bit selector, but the present disclosure is not limited thereto. The number of bits of the capacitance selector 310 may be optional.

The capacitance selector 310 includes a first output terminal to an eighth output terminal. The first output terminal to the eighth output terminal of the capacitance selector 310 are electrically connected to one input terminals of the AND gate circuits 331 to 338, respectively. The capacitance selector 310 selectively outputs control signals to the one input terminals of the AND gate circuits 331 to 338, respectively, in accordance with the control signals S7 input to the first to third input terminals 311 to 313.

The resistance selector 320 includes a first input terminal 321, a second input terminal 322, and a third input terminal 323. The resistance selector 320 is configured such that the control signals S7 from the control device 30A are input to the first to third input terminals 321 to 323, respectively. That is, the resistance selector 320 is a 3-bit selector. In the second embodiment, the resistance selector 320 will be described as the 3-bit selector, but the present disclosure is not limited thereto. The number of bits of the resistance selector 320 may be optional.

The first output terminal to the eighth output terminal of the capacitance selector 310 are electrically connected to the one input terminals of the AND gate circuits 331 to 338, respectively. An input terminal 301 is electrically connected to the other input terminals of the AND gate circuits 331 to 338. The input terminal 301 receives the control signal from the signal source 140. The output terminals of the AND gate circuits 331 to 338 are electrically connected to gate terminals of the capacitance transistors 341 to 348, respectively.

The AND gate circuit 330 outputs a high-level output signal when a high-level control signal is input to both one input terminal and the other input terminal. The capacitance selector 310 always outputs the high-level control signal to at least one input terminal of the AND gate circuit 331. The signal source 140 outputs the control signal to the other input terminal of the AND gate circuit 330.

The capacitance transistors 341 to 348 are, for example, metal oxide semiconductor field Effect Transistors (MOSFETs), but are not limited thereto.

The gate terminals of the capacitance transistors 341 to 348 are electrically connected to the output terminals of the AND gate circuits 331 to 338, respectively. Drain terminals of the capacitance transistors 341 to 348 are electrically connected to an output terminal 302. Source terminals of the capacitance transistors 341 to 348 are electrically connected to one terminals of the capacitors 351 to 358, respectively.

The capacitor transistor 340 is switched from the open state to the closed state when the high-level output signal is input from the AND gate circuit 330 to the gate terminal. When the capacitor transistor 340 is switched from the open state to the closed state, the capacitor 350 is electrically connected to the output terminal 302. Thus, the capacitance of the capacitor 350 is added to the capacitor circuit 120A.

One terminals of the capacitors 351 to 358 are electrically connected to the source terminals of the capacitance transistors 341 to 348, respectively. The other terminals of the capacitors 351 to 358 are electrically connected to drain terminals of the compensation transistors 361 to 368, respectively.

For example, when a target value of the capacitance value of the capacitor circuit 120A is C [picofarad (pF)], a capacitance value of the capacitor 351 may be 0.7C [pF]. Capacitance values of the capacitors 352 to 358 may be, for example, 0.1C [pF].

The compensation circuit 300 can selectively add the capacitance values from 0.7C to 1.4C to the transmission circuit 28A in increments of 0.1C with respect to a reference capacitance value of 0.7C by sequentially controlling the capacitance transistors 341 to 348 to be in the on state. Specifically, when only the capacitor transistor 341 is in the closed state, 0.7C is added to the transmission circuit 28A, and when the capacitor transistor 341 and the capacitor transistor 342 are in the on state, 0.8C is added to the transmission circuit 28A. That is, in the second embodiment, the capacitance value added to the capacitor circuit 120A can be optionally selected between 0.7C and 1.4C.

The gate terminals of the compensation transistors 361 to 368 are electrically connected to the first to eighth output terminals of the Resistance selector 320, respectively. The drain terminals of the compensation transistors 361 to 368 are electrically connected to the other terminals of the capacitors 351 to 358, respectively. Source terminals of the compensation transistors 361 to 368 are electrically connected to the reference potential. For example, the reference potential is a ground, but not limited thereto.

The compensation transistor 360 is switched from the open state to the closed state when the high-level output signal is input to the gate signal from the Resistance selector 320. When the compensation transistor 360 is switched from the open state to the closed state, a parasitic resistance of the compensation transistor 360 is added to the capacitor transistor 340. That is, the compensation circuit 300 selectively adds the parasitic resistances of the compensation transistors 361 to 368 to the capacitance transistors 341 to 348, respectively.

Each of the capacitance transistors 341 to 348 has a parasitic resistance. It is also assumed that characteristics of the transmission circuit 28A change in accordance with variations in the resistance values of the parasitic resistances of the capacitance transistors 341 to 348. Thus, by selectively adding the resistance values of the parasitic resistances of the compensation transistors 361 to 368 in accordance with the resistance values of the parasitic resistances of the capacitance transistors 341 to 348, respectively, an influence of a specific variation can be compensated.

A method of rotationally controlling impedance according to the second embodiment is the same as the method according to the first embodiment, and thus the description thereof will be omitted.

As described above, in the second embodiment, the capacitance value and the resistance value can be selectively added to the transmission circuit 28A. As a result, in the second embodiment, an influence on the characteristics caused by variations in the capacitance value and the resistance value of the capacitor circuit 120A can be compensated.

Third Embodiment

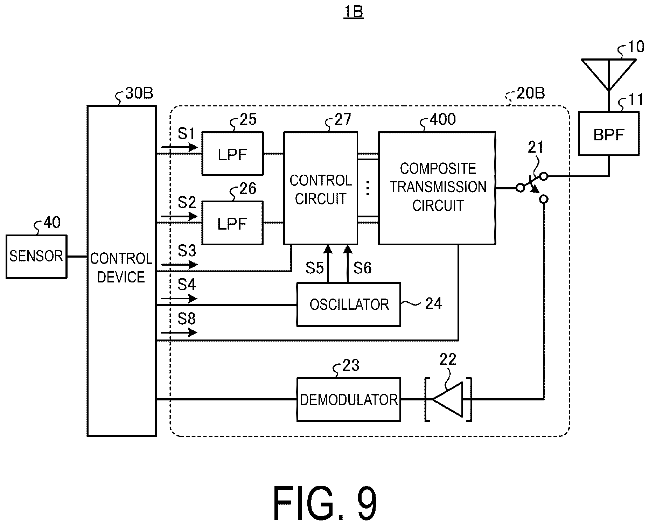

A configuration of a wireless communication device according to a third embodiment will be described with reference to FIG. 9. FIG. 9 is a block diagram illustrating an example of the configuration of the wireless communication device according to the third embodiment.

As illustrated in FIG. 9, a wireless communication device 1B is different from the wireless communication device 1 illustrated in FIG. 1 in that the wireless communication device 1B includes a composite transmission circuit 400 and in that a control device 30B outputs a control signal S8 to the composite transmission circuit 400. The composite transmission circuit 400 includes a plurality of transmission circuits.

Composite Transmission Circuit

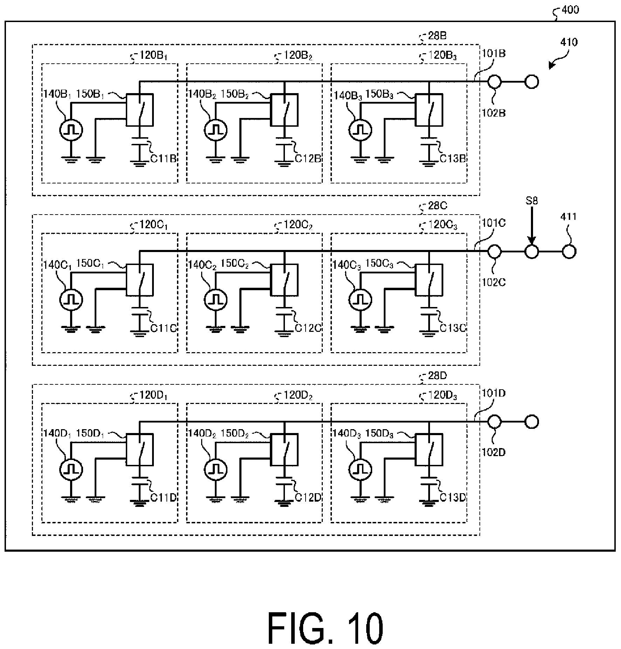

The configuration of the composite transmission circuit according to the third embodiment will be described with reference to FIG. 10. FIG. 10 is a diagram for describing an example of the configuration of the composite transmission circuit according to the third embodiment.

As illustrated in FIG. 10, the composite transmission circuit 400 includes a first transmission circuit 28B, a second transmission circuit 28C, a third transmission circuit 28D, and a switch circuit 410.

The first transmission circuit 28B includes capacitor circuits $120B_1$ to $120B_3$. The capacitor circuits $120B_1$ to $120B_3$ include signal sources $140B_1$ to $140B_3$, switch elements $150B_1$ to $150B_3$, and capacitors C11B to C13B, respectively. The capacitor circuits $120B_1$ to $120B_3$ are electrically connected to one another by a signal line 101B. The signal line 101B is electrically connected to an input/output terminal 102B. Specific configurations of the capacitor circuits $120B_1$ to $120B_3$ are same as and/or similar to those of the transmission circuit 28 illustrated in FIG. 4, and thus description thereof will be omitted.

The second transmission circuit 28C includes capacitor circuits $120C_1$ to $120C_3$. The capacitor circuits $120C_1$ to $120C_3$ include signal sources $140C_1$ to $140C_3$, switch elements $150C_1$ to $150C_3$, and capacitors C11C to C13C, respectively. The capacitor circuits $120C_1$ to $120C_3$ are electrically connected to one another by a signal line 101C. The signal line 101C is electrically connected to an input/output terminal 102C. Specific configurations of the capacitor circuits $120C_1$ to $120C_3$ are same as and/or similar to those of the transmission circuit 28 illustrated in FIG. 4, and thus description thereof will be omitted.

The third transmission circuit 28D includes capacitor circuits $120D_1$ to $120D_3$. The capacitor circuits $120D_1$ to $120D_3$ include signal sources $140D_1$ to $140D_3$, switch elements $150D_1$ to $150D_3$, and capacitors C11D to C13D, respectively. The capacitor circuits $120D_1$ to $120D_3$ are electrically connected to one another by a signal line 101D. The signal line 101D is electrically connected to an input/output terminal 102D. Specific configurations of the capacitor circuits $120D_1$ to $120D_3$ are same as and/or similar to those of the transmission circuit 28 illustrated in FIG. 4, and thus description thereof will be omitted.

The first transmission circuit 28B, the second transmission circuit 28C, and the third transmission circuit 28D have characteristics different from each other with respect to the capacitance value and the resistance value.

The first transmission circuit 28B is, for example, a transmission circuit having characteristics of a center value in a design value. Specifically, the first transmission circuit 28B is a transmission circuit in which the capacitance value, the resistance value, and a characteristic value of the switch element 150B (transistor) each have characteristics of center values of design values. The characteristic of the center value is also referred to as a first characteristic.

The second transmission circuit 28C is, for example, a transmission circuit having characteristics of an upper limit value in the design value. Specifically, the second transmission circuit 28C is a transmission circuit in which the capacitance value, the resistance value, and the characteristic value of the switch element 150C (transistor) each have characteristics of the upper limit value of the design value. The characteristic of the upper limit value is also referred to as a second characteristic.

The third transmission circuit 28D is, for example, a transmission circuit having characteristics of a lower limit value in the design value. Specifically, the third transmission circuit 28D is a transmission circuit in which the capacitance value, the resistance value, and the characteristic value of the switch element 150D (transistor) each have characteristics of the lower limit value of the design value. The characteristic of the lower limit value is also referred to as a third characteristic.

The switch circuit 410 includes an input/output terminal 411. The input/output terminal 411 is electrically connected to the radio frequency switch 21 illustrated in FIG. 9.

The switch circuit 410 electrically connects any one of the input/output terminals 102B, 102C, and 102D to the input/output terminals 411. That is, the switch circuit 410 electrically connects any one of the first transmission circuit 28B, the second transmission circuit 28C, and the third transmission circuit 28D to the antenna 10. The switch circuit 410 electrically connects any one of the first transmission circuit 28B, the second transmission circuit 28C, and the third transmission circuit 28D to the antenna 10 in accordance with, for example, the control signal S8 from the control device 30B. The control device 30B is a kind of a switch controller.

The control device 30B controls any one of the first transmission circuit 28B, the second transmission circuit 28C, and the third transmission circuit 28D to be electrically connected to the antenna 10 in accordance with the overall characteristics of the wireless communication device 1B. After electrically connecting any one of the first transmission circuit 28B, the second transmission circuit 28C, and the third transmission circuit 28D to the antenna 10, the control device 30B may dynamically change the transmission circuit to be electrically connected to the radio frequency switch 21.

In the third embodiment, the composite transmission circuit 400 has been described as including the three transmission circuits, but the present disclosure is not limited thereto. The composite transmission circuit 400 may include, for example, two transmission circuits including the transmission circuit of the center value of the design value and the transmission circuit of the upper limit value or the lower limit value of the design value. The composite transmission circuit 400 may include, for example, two transmission circuits including the transmission circuit of the upper limit value of the design value and the transmission circuit of the lower limit value of the design value. The composite transmission circuit 400 may include, for example, 27 transmission circuits each designed by a combination of the upper limit value, the center value, and the lower limit value of each of the capacitance value, the resistance value, and the characteristic value of the switch element.

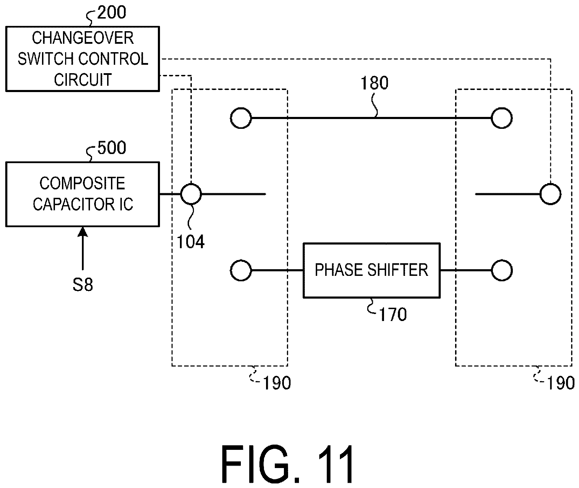

A method of rotationally controlling the impedance in the complex plane in the transmission circuit according to the third embodiment will be described with reference to FIG. 11. FIG. 11 is a diagram for describing the method of rotationally controlling the reflection coefficient in the complex plane according to the third embodiment.

As illustrated in FIG. 11, the composite transmission circuit 400 illustrated in FIG 10 may be integrated and used as a composite capacitor IC 500. In this case, the composite capacitor IC 500 is connected to either a phase shifter 170 or a signal line 180 by switching of a changeover switch element 190 by a changeover switch control circuit 200.

The plurality of transmission circuits included in the composite capacitor IC 500 are configured such that any one of the plurality of transmission circuits is electrically connected to the input/output terminal 104 by, for example, the control signal S8 from the control device 30B.

The method of rotationally controlling impedance according to the third embodiment is the same as the method according to the first embodiment, and thus the description thereof will be omitted.

As described above, the third embodiment can control any one of the first transmission circuit 28B, the second transmission circuit 28C, and the third transmission circuit 28D having different characteristics from each other to be electrically connected to the antenna 10 in accordance with the overall characteristics of the wireless communication device 1B. Thus, the third embodiment can compensate variations in characteristics of the wireless communication device 1B at the time of manufacturing.

Embodiments of the present disclosure have been described above, but the present disclosure is not limited by the contents of the embodiments. Constituent elements described above include those that can be easily assumed by a person skilled in the art, those that are substantially identical to the constituent elements, and those within a so-called range of equivalency. The constituent elements described above can be combined as appropriate. Various omissions, substitutions, or modifications of the constituent elements can be made without departing from the spirit of the above-described embodiments.

REFERENCE SIGNS

    1 Wireless communication device
    10 Antenna
    11 BPF
    20 RFBS device
    21 Radio frequency switch
    22 Amplifier
    23 Demodulator
    24 Oscillator
    25, 26 LPF
    27 Control circuit
    28 Transmission circuit
    30 Control device
    40 Sensor
    120 Capacitor circuit
    140 Signal source
    150 Switch element
    160 Capacitor IC
    170 Phase shifter
    200 Changeover switch control circuit
    300 Compensation circuit
    310 Capacitance selector
    320 Resistance selector
    330 AND gate circuit
    340 Capacitance transistor
    350 Capacitor
    360 Compensation transistor

**Claims**

1. A transmission circuit configured to be connected to an antenna, the transmission circuit comprising:

    a plurality of impedance circuits having different impedance from each other;
    a plurality of switch elements each of which is connected to a respective one of the plurality of impedance circuits;
    a compensation circuit connected to each of the plurality of switch elements and configured to selectively add a capacitance value and a resistance value to the transmission circuit; and
    a control circuit configured to control opening/-closing of the plurality of switch elements, wherein
    the control circuit is controllable to selectively change the opening/closing of the plurality of switch elements and to rotate a reflection coefficient of an output terminal on the antenna side in a complex plane.

2. The transmission circuit according to claim 1, wherein
    the compensation circuit comprises a plurality of capacitors selectively connected to the impedance circuit and a plurality of resistive elements selectively connected to the impedance circuit.

3. The transmission circuit according to claim 2, wherein
    the control circuit is configured to selectively connect the plurality of capacitors and the plurality of resistive elements to the impedance circuit in accordance with a capacitance value and a resistance value of the transmission circuit.

4. The transmission circuit according to any one of claims 1 to 3, wherein
    the plurality of impedance circuits comprise a plurality of inductor circuits configured to adjust inductance among reactance components of impedance.

5. The transmission circuit according to any one of claims 1 to 4, wherein
    the plurality of impedance circuits comprise a plurality of capacitor circuits configured to adjust capacitance among reactance components of impedance.

6. A composite transmission circuit configured to be connected to an antenna, the composite transmission circuit comprising at least:

    a first transmission circuit having a first characteristic related to a capacitance value and a resistance value;
    a second transmission circuit having a second characteristic different from the first characteristic with respect to a capacitance value and a resistance value; and
    a third transmission circuit having a third characteristic different from the first characteristic and the second characteristic with respect to a capacitance value and a resistance value, the composite transmission circuit comprising a switch control circuit configured to selectively connect the first transmission circuit, the second transmission circuit, and the third transmission circuit to the antenna, wherein each of the first transmission circuit, the second transmission circuit, and the third transmission circuit comprises:

a plurality of impedance circuits having different impedance from each other;
a plurality of switch elements each of which is connected to a respective one of the plurality of impedance circuits; and
a control circuit configured to control opening/closing of the plurality of switch elements, and

the control circuit is controllable to selectively change the opening/closing of the plurality of switch elements and to rotate a reflection coefficient of an output terminal on the antenna side in a complex plane.

7. The composite transmission circuit according to claim 6, wherein the switch control circuit is configured to selectively connect the first transmission circuit, the second transmission circuit, and the third transmission circuit to the antenna in accordance with a degree of variations in the first characteristic, the second characteristic, and the third characteristic.

FIG. 1

FIG. 2

# FIG. 3A

# FIG. 3B

# FIG. 3C

FIG. 4

EP 4 485 809 A1

FIG. 5

<u>1A</u>

# FIG. 6

FIG. 7

FIG. 8

1B

FIG. 9

FIG. 10

200

CHANGEOVER
SWITCH CONTROL
CIRCUIT

180

500

COMPOSITE
CAPACITOR IC

104

S8

PHASE SHIFTER

170

190

190

# FIG. 11

## INTERNATIONAL SEARCH REPORT

| | International application No. |
|---|---|
| | **PCT/JP2023/003628** |

**A. CLASSIFICATION OF SUBJECT MATTER**

*H04B 5/02*(2006.01)i; *H03H 7/38*(2006.01)i; *H04B 1/59*(2006.01)i
FI:   H04B5/02; H04B1/59; H03H7/38 B

According to International Patent Classification (IPC) or to both national classification and IPC

**B. FIELDS SEARCHED**

Minimum documentation searched (classification system followed by classification symbols)

H04B5/02; H03H7/38; H04B1/59

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2005-202721 A (MATSUSHITA ELECTRIC IND CO LTD) 28 July 2005 (2005-07-28) fig. 2 | 1-7 |
| A | US 2020/0328625 A1 (KONINKLIJKE PHILIPS N.V.) 15 October 2020 (2020-10-15) paragraph [0156] | 1-7 |
| P, A | JP 2022-56169 A (TOKYO INST TECH) 08 April 2022 (2022-04-08) paragraphs [0021]-[0034], fig. 2 | 1-7 |
| P, A | JP 2022-56911 A (TOKYO INST TECH) 11 April 2022 (2022-04-11) paragraphs [0021]-[0031], fig. 2 | 1-7 |
| P, A | JP 2022-56139 A (TOKYO INST TECH) 08 April 2022 (2022-04-08) paragraphs [0021], [0030], [0049]-[0087], fig. 2, 4, 6-7, 9, 11 | 1-7 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 February 2023** | **14 March 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/003628**

| Patent document cited in search report | | | Publication date (day/month/year) | Patent family member(s) | | | Publication date (day/month/year) |
|---|---|---|---|---|---|---|---|
| JP | 2005-202721 | A | 28 July 2005 | (Family: none) | | | |
| US | 2020/0328625 | A1 | 15 October 2020 | WO | 2017/174380 | A1 | |
| | | | | CN | 109075816 | A | |
| JP | 2022-56169 | A | 08 April 2022 | WO | 2022/070675 | A1 | |
| JP | 2022-56911 | A | 11 April 2022 | WO | 2022/070672 | A1 | |
| JP | 2022-56139 | A | 08 April 2022 | WO | 2022/070676 | A1 | |

Form PCT/ISA/210 (patent family annex) (January 2015)

**EP 4 485 809 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005323223 A